# EUROPÄISCHE PATENTSCHRIFT

(11) **EP 1 688 989 B1**
(45) Veröffentlichungstag und Bekanntmachung des Hinweises auf die Patenterteilung: **23.04.2008**
(21) Anmeldenummer: 06001686.2
(22) Anmeldetag: 27.01.2006
(51) Int. Cl.: H01L 21/331, H01L 29/737, H01L 21/3105

(54) **Verfahren zur Herstellung integrierter Schaltkreise mit mindestens einem Silizium-Germanium-Heterobipolartransistor**
Method of manufacturing integrated circuits comprising at least one silicon germanium heterobipolar transistor
Méthode de fabrication de circuits intégrés comportant au moins un transistor bipolaire à hétérojonction

(30) Priorität: 02.02.2005 DE 102005004708
(43) Veröffentlichungstag der Anmeldung: 09.08.2006
(73) Patentinhaber: ATMEL Germany GmbH, 74072 Heilbronn (DE)
(72) Erfinder: Brandl, Peter, Dipl.-Ing., 9500 Villach (AT)
(74) Vertreter: Müller, Wolf-Christian

(56) Entgegenhaltungen:
- EP-A- 0 367 698
- EP-A- 0 637 065
- US-A- 5 234 847
- US-A1- 2004 245 583
- PATENT ABSTRACTS OF JAPAN Bd. 1998, Nr. 08, 30. Juni 1998 (1998-06-30) -& JP 10 070098 A (SONY CORP), 10. März 1998 (1998-03-10)
- VAN HUYLENBROECK S ET AL: "Lateral and vertical scaling of a QSA HBT for a 0.13/spl mu/m 200GHz SiGe:C BiCMOS technology" BIPOLAR/BICMOS CIRCUITS AND TECHNOLOGY, 2004. PROCEEDINGS OF THE 2004 MEETING MONTREAL, CANADA SEPT. 12-14, 2004, PISCATAWAY, NJ, USA,IEEE, 12. September 2004 (2004-09-12), Seiten 229-232, XP010746096 ISBN: 0-7803-8618-3
- JOHN J P ET AL: "Elimination of NPN C-E leakage yield loss in SiGe: C HBT BiCMOS technology through optimization of critical wet chemical wafer treatments" 2003 IEEE INTERNATIONAL SYMPOSIUM ON SEMICONDUCTOR MANUFACTURING. CONFERENCE PROCEEDINGS. ( ISSM 2003 ). SAN JOSE, CA, SEPT. 30 - OCT. 2, 2003, IEEE INTERNATIONAL SYMPOSIUM ON SEMICONDUCTOR MANUFACTURING, NEW YORK, NY : IEEE, US, 30. September 2003 (2003-09-30), Seiten 411-414, XP010667484 ISBN: 0-7803-7894-6
- KEMPF P ET AL: "Silicon germanium BICMOS technology" GAAS IC SYMPOSIUM. 24TH. ANNUAL IEEE GALLIUM ARSENIDE INTEGRATED CIRCUIT SYMPOSIUM. TECHNICAL DIGEST 2002. MONTEREY, CA, OCT. 20-23, 2002, GAAS IC SYMPOSIUM - IEEE GALLIUM ARSENIDE INTEGRATED CIRCUIT SYMPOSIUM, NEW YORK, NY : IEEE, US, 20. Oktober 2002 (2002-10-20), Seiten 3-6, XP010616111 ISBN: 0-7803-7447-9
- OSTEN H J ET AL: "Dopant diffusion control by adding carbon into Si and SiGe: principles and device application" MATERIALS SCIENCE AND ENGINEERING B, ELSEVIER SEQUOIA, LAUSANNE, CH, Bd. 87, Nr. 3, 19. Dezember 2001 (2001-12-19), Seiten 262-270, XP004310485 ISSN: 0921-5107

## Beschreibung

Die vorliegende Erfindung betrifft ein Verfahren zur Herstellung integrierter Schaltkreise mit mindestens einem Silizium-Germanium-Heterobipolartransistor.

Aus dem Stand der Technik sind Halbleiterschaltkreise und Verfahren zur Herstellung derselben bekannt, die Heterobipolartransistoren mit einem Silizium-Germanium-Mischkristall im Basishalbleitergebiet aufweisen. Beispielsweise aus der EP 0 367 698 A2 ist die Herstellung eines Hetero-Junction-Bipolartransistors bekannt. Ein Emitterhalbleitergebiet ist mit einer SiO₂-Schicht und einer Metallschicht bedeckt, die zusammen eine Erhöhung bilden. Über diese Topographie ist eine Oxidschicht abgeschieden. Auf der Oxidschicht ist eine Polyimidschicht abgeschieden. Zunächst wird bis zur Höhe der Metallschicht die Struktur zurückgeätzt. Anschließend erfolgt eine weitere Ätzung bis zur Emitterschicht oder ein CMP (Chemical-Mechanical Polishing) bis zur Emitterschicht. Ein zweistufiges Polierverfahren ist aus der JP 10070098 A bekannt, dass drei Polierstoppschichten und zwei zu polierende Schichten aufweist. Ein weiteres Polierverfahren ist aus der EP 637 065 bekannt, welches eine Ätzstoppschicht aufweist.

Aufgabe der vorliegenden Erfindung ist es das Verfahren zur Herstellung der integrierten Schaltkreise weiter zu entwickeln. Diese Aufgabe wird erfindungsgemäß durch ein Verfahren mit den Merkmalen des Anspruchs 1 und eine Verwendung des Verfahrens nach Anspruch 9, gelöst. Vorteilhafte Weiterbildungen der Erfindung sind Gegenstand von Unteransprüchen.

Demgemäß wird in dem Verfahren zur Herstellung eines integrierten Schaltkreises ein auf die Oberfläche des Wafers aufgebrachtes Dielektrikum planarisiert. Der Wafer ist vorzugsweise ein einkristalliner Siliziumwafer mit beispielsweise einer Gitterorientierung von <100>. Das Dielektrikum ist beispielsweise Siliziumdioxid (SiO₂), wobei die Erfindung auch andere, planarisierbare Dielektrika mit umfasst. Das Dielektrikum aus Siliziumdioxid kann in seiner späteren Funktion auch als Feldoxid bezeichnet werden.

Das Dielektrikum weist Erhebungen auf, die durch die Dicke von unterhalb des Dielektrikums strukturierten, monokristallinen Halbleitergebieten verursacht sind. Diese monokristallinen Halbleitergebiete sind beispielsweise epitaktisch aufgebrachte Kollektorhalbleitergebiete von Hochfrequenzbipolartransistoren. Zusätzlich zu den monokristallinen Halbleitergebieten können auch andere Strukturunebenheiten unterhalb des Dielektrikums zur Ausbildung von Erhebungen führen. Die monokristallinen Halbleitergebiete sind durch eine erste Stoppschicht bedeckt. Zwischen der ersten Stoppschicht und dem monokristallinen Halbleitergebiet kann dabei eine gegenüber der Stoppschicht dünnere Schicht aus dem Dielektrikummaterial angeordnet sein.

Unter "nachfolgend" wird im Folgenden verstanden, dass dieser eine oder mehrere "nachfolgende" Prozessschritte im Gesamt-Herstellungsprozess zeitlich später erfolgen. Dabei ist kein unmittelbares Aneinanderanschließen der Prozessschritte erforderlich, sondern vor den folgenden Prozessschritten können weitere Prozessschritte, wie beispielsweise Reinigungsschritte, eingefügt werden.

Das Wesen der Erfindung besteht dabei in der Kombination der nachfolgend beschriebenen Prozessschritte. Dabei ist zunächst vorgesehen, dass zur Planarisierung auf das Dielektrikum eine zweite Stoppschicht aufgebracht wird und nachfolgend auf die zweite Stoppschicht eine Planarisierungsschicht aufgebracht wird, die im Bereich jeder der Erhebungen eine geringere Schichtdicke als außerhalb des Bereichs jeder Erhebung ausbildet. Beispielsweise kann die Schichtdicke der Planarisierungsschicht um die Hälfte variieren.

Diesen Prozessschritten wiederum nachfolgend werden die Planarisierungsschicht im Bereich jeder Erhebung und die zweite Stoppschicht im Bereich jeder Erhebung durch Ätzen entfernt. Die Planarisierungsschicht wird im Bereich jeder Erhebung durch Ätzen derart entfernt, dass außerhalb des Bereichs eine verbliebene Planarisierungsschicht die zweite Stoppschicht bedeckt. Zur Entfernung der zweiten Stoppschicht wird diese ausschließlich im Bereich jeder Erhebung geätzt, indem das Material der zweiten Stoppschicht einem Ätzmittel ausgesetzt wird, das hinsichtlich der zweiten Stoppschicht eine gegenüber der Planarisierungsschicht geringere Ätzrate bewirkt.

Wiederum nachfolgend wird der Wafer derart chemisch-mechanisch poliert, dass das Dielektrikum im Bereich jeder Erhebung bis zur ersten Stoppschicht gedünnt wird. Außerhalb des Bereichs jeder Erhebung wird das Dielektrikum dagegen nicht oder nur geringfügig gedünnt. Die erste Stoppschicht und die zweite Stoppschicht wirken daher als Polierstopp, der den durch das chemisch-mechanische Polieren bedingten Abtrag von Oberflächenmaterial signifikant reduziert.

Eine vorteilhafte Weiterbildung der Erfindung sieht vor, dass vor dem chemisch-mechanischen Polieren (CMP) die außerhalb des Bereichs jeder Erhebung verbliebene Planarisierungsschicht entfernt wird. Hierzu kann die verbliebene Planarisierungsschicht beispielsweise mit einem gegenüber dem Dielektrikum und der Stoppschicht selektiv wirkendem Ätzmittel geätzt werden.

Vorzugsweise werden nach dem chemisch-mechanischen Polieren (CMP) die freiliegende erste Stoppschicht und/oder die freiliegende zweite Stoppschicht entfernt.

In einer anderen vorteilhaften Weiterbildung der Erfindung ist vorgesehen, dass die Planarisierungsschicht im Bereich jeder Erhebung derart entfernt wird, dass außerhalb des Bereichs jeder Erhebung eine Planarisierungsrestschicht einer derartigen Dicke verbleibt, dass eine Ätzung der von der Planarisierungsschicht bedeckten zweiten Stoppschicht nicht oder nur unwesentlich erfolgt. Zumindest verbleibt die Funktion der zweiten Stoppschicht als Polierstopp für das chemisch-mechanische Polieren sichergestellt.

Eine bevorzugte Weiterbildung der Erfindung sieht vor, dass das Dielektrikum, die erste Stoppschicht und die zweite Stoppschicht derart aufgebracht werden, dass eine Parallelverschiebung der gleichsinnig orientierten Oberflächen der ersten Stoppschicht und der zweiten Stoppschicht kleiner ist als eine Dicke der ersten Stoppschicht und/oder als eine Dicke der zweiten Stoppschicht. Demzufolge ist das Aufbringen des Dielektrikum engtolerant zur Dicke der monokristallinen Halbleitergebiete auszugestalten.

Gemäß einer vorteilhaften Ausgestaltung der Erfindung wird zum Entfernen der Planarisierungsschicht im Bereich jeder Erhebung die Planarisierungsschicht in Abhängigkeit von einer Zeitmessung geätzt.

Weiterhin ist vorteilhafterweise vorgesehen, dass die erste Stoppschicht und/oder die zweite Stoppschicht Siliziumnitrid, (Si₃N₄) aufweist, das gegenüber dem chemisch-mechanischen Polieren einen geringeren Abtragswert aufweist als beispielsweise das Siliziumdioxid des Dielektrikum.

Um die gewünschten Planarisierungseffekte durch die Planarisierungsschicht zu erreichen, ist in vorteilhaften Ausgestaltungen der Erfindung vorgesehen, dass die Planarisierungsschicht einen Photolack oder ein Polymer aufweist. Dabei kann die Planarisierungsschicht auch aus mehreren Einzelschichten gleicher oder unterschiedlicher Materialien bestehen, die in der kombinierten Verwendung die Planarisierungswirkung verstärken. Wird beispielsweise ein Photolack verwendet, kann dieser durch Aufschleudern vorteilhaft aufgebracht werden.

Es ist möglich ein Verfahren zur Herstellung integrierter Schaltkreise mit Silizium - Germanium - Heterobipolartransistoren mit einer Modularisierung des Herstellungsverfahrens vorzusehen. Dabei ist das Herstellungsverfahren in mehrere Verfahrensmodule aufgegliedert. Ein Verfahrensmodul weist dabei einen, vorzugsweise jedoch zumindest zwei Prozessschritte des Herstellungsverfahrens auf. Zur Aufgliederung sind mehrere oder alle Prozessschritte in Modulen zusammengefasst.

Als Verfahrensmodule sind
- ein Anschlussmodul zur Erzeugung eines vergrabenen Anschlussgebietes,
- ein Kollektor-Emitter-Modul zur Erzeugung eines, an das Anschlussgebiet angrenzenden Kollektorgebietes und/oder eines, an das Anschlussgebiet angrenzenden Emittergebietes, und
- ein Basismodul zur Erzeugung eines Basisgebietes
definiert.

Unter einem vergrabenen Anschlussgebiet wird ein leitfähiges Gebiet verstanden, das bezüglich der Waferoberfläche zumindest teilweise unterhalb eines aktiven Halbleitergebiets insbesondere des Heterobipolartransistors angeordnet ist. Es ist möglich, dass das aktive Halbleitergebiet zumindest teilweise monokristallin ist. Das Halbleitergebiet der Basis kann unmittelbar an das Kollektorgebiet und/oder an das Emittergebiet grenzen, das zumindest an der Grenzfläche monokristallin ausgebildet ist.

Dabei ist eine Entwicklung einer von der bestehenden Technologieversion abweichenden Technologieversion möglich, indem die Verfahrensmodule zueinander derartige Verfahrensschnittstellen aufweisen, dass zumindest ein Prozessschritt eines Verfahrensmoduls unter Einhaltung der Verfahrensschnittstelle unabhängig von den Prozessschritten der übrigen Verfahrensmodule für die abweichende Technologieversion geändert wird.

Die Verfahrenschnittstellen können eine oder mehrere Verfahrensbedingungen aufweisen, die Prozesse von mindestens zwei Modulen betreffen. Beispielsweise betrifft ein Hochtemperatur-Epitaxie-Prozessschritt im Kollektor-Emitter-Modul sowohl die Diffusion und somit die Dotierstoffverteilung der im Anschlussmodul als auch die Diffusion und somit die Dotierstoffverteilung der im Kollektor-Emitter-Modul eingebrachten Dotierstoffe, die während des Hochtemperatur-Epitaxie-Prozessschritts diffundieren.

Technologieversionen unterscheiden sich dann, wenn sich die elektrischen Eigenschaften zumindest eines integrierten Bauelementes mit dem Technologiewechsel ändern. Mit der neuen Technologieversion kann der Heterobipolartransistor den gewünschten Spezifikationen angepasst werden.

Die Erzeugung der hochdotierten, metallischen und/oder silizidierten Zuleitungen für die zuvor genannten Gebiete kann dabei ein Bestandteil des jeweiligen Verfahrensmoduls sein und/oder ein oder mehrere separate Verfahrensmodule bilden.

Zumindest ein Verfahrensmodul kann zumindest zwei Modulvarianten aufweisen. Die Modulvarianten werden dabei in ein und derselben Technologieversion verwendet, um unterschiedliche Bauelemente mit einer reduzierten Anzahl von nötigen Prozessschritten zu erzeugen. Die zumindest zwei Modulvarianten können auf demselben integrierten Schaltkreis durchgeführt werden. Beispielsweise kann eine erste Modulvariante zur Erzeugung eines Kollektorgebietes und eine zweite Modulvariante zur zumindest teilweise parallelen Erzeugung eines Emittergebietes ausgestaltet werden.

Eine Erste der Verfahrensschnittstellen zwischen Anschlussmodul und Kollektor-Emitter-Modul kann in einer Abfolge der Prozessschritte vor einem epitaktischen Aufbringen von Halbleitermaterial des Kollektorgebietes und/oder des Emittergebietes gesetzt sein.

Eine der Verfahrensschnittstellen zwischen Kollektor-Emitter-Modul und Basismodul kann in einer Abfolge der Prozessschritte nach dem Planarisieren des Dielektrikums gesetzt sein. Dies kann beispielsweise eine zweite Verfahrensschnittstelle zu der zuvor genannten sein, so dass der Herstellungsprozess zumindest drei Verfahrensmodule aufweist.

Eine Verwendung des zuvor erläuterten Herstellungsverfahrens einer Halbleiteranordnung ermöglicht eine Anpassung der Technologieversion an applikationsspezifische Randbedingungen.

Ein Aspekt der Erfindung ist eine Verwendung des Verfahrens zur Herstellung eines integrierten Hochfrequenzschaltkreises mit zumindest einem Silizium-Germanium-Heterobipolartransistor.

Im Folgenden wird die Erfindung durch Ausführungsbeispiele anhand zeichnerischer Darstellungen näher erläutert.

Dabei zeigen
- Fig. 1: Verfahrensmodule mit zugeordneten Verfahrensschnittstellen,
- Fig. 2a: eine erste schematische Schnittansicht nach Prozessschritten der Herstellung einer Halbleiteranordnung,
- Fig. 2b: eine zweite schematische Schnittansicht nach Prozessschritten der Herstellung einer Halbleiteranordnung,
- Fig. 2c: eine dritte schematische Schnittansicht nach Prozessschritten der Herstellung einer Halbleiteranordnung,
- Fig. 2d: eine vierte schematische Schnittansicht nach Prozessschritten der Herstellung einer Halbleiteranordnung, und
- Fig. 2e: eine fünfte schematische Schnittansicht nach Prozessschritten der Herstellung einer Halbleiteranordnung.

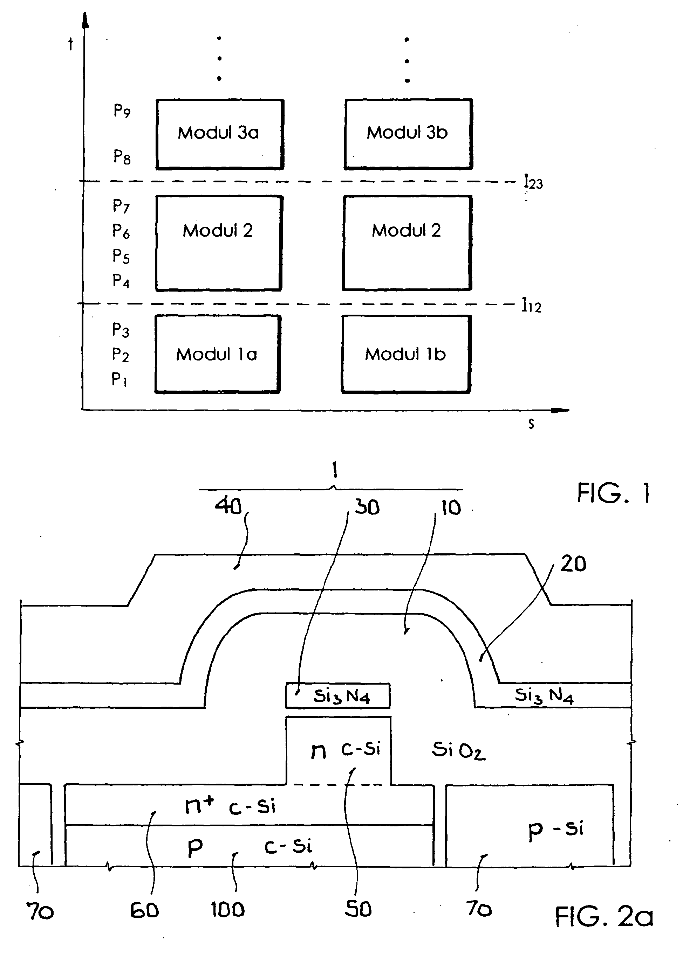

Gemäß Fig. 1 ist das Herstellungsverfahren für eine Halbleiteranordnung mit einem Silizium-Germanium-Heterobipolartransistor in mehrere Verfahrensmodule Modul 1a, Modul 1b, Modul 2, Modul 3a und Modul 3b unterteilt. Dabei zeigt die Modulaufteilung des Ausführungsbeispiels der Fig. 1 sowohl für das erste Modul (Modul 1a/Modul 1b) eine erste Modulvariante Modul 1a und eine zweite Modulvariante Modul 1b als auch für das dritte Modul die Modulvarianten Modul 3a und Modul 3b.

Das Ausführungsbeispiel der Fig. 1 zeigt beispielhaft die Aufteilung in drei Verfahrensmodule, wobei sowohl die Modulvariante 1a mit dem Modul 2 und der Modulvariante 3a, die Modulvariante 1a mit dem Modul 2 und der Modulvariante 3b, die Modulvariante 1 b mit dem Modul 2 und der Modulvariante 3a als auch die Modulvariante 1b mit dem Modul 2 und der Modulvariante 3b kombiniert werden können, um Transistoren mit unterschiedlichen elektrischen Eigenschaften auf einem Halbleiterchip zu erzeugen. Das erste Modul (Modul1a, Modul 1b), das zweite Modul 2 und das dritte Modul (Modul 3a, 3b) folgen gemäß dem Ausführungsbeispiel der Fig. 1 aufeinander nach der Zeit t.

Die Module Modul 1a, Modul 1b, Modul 2, Modul 3a und Modul 3b weisen jeweils einen mehrere Prozessschritte P1 bis P3, P4 bis P7, beziehungsweise P8 bis P9 des Herstellungsverfahrens auf, die auch für unterschiedliche Modulvarianten identisch sind. Varianten der Module können beispielsweise durch eine entsprechende Maskierung und somit durch einen seitlichen Versatz s auf dem Wafer erzeugt werden.

Die Module Modul 1a, Modul 1b, Modul 2, Modul 3a und Modul 3b sind dabei durch Verfahrenschnittstellen I₁₂, I₂₃ zueinander definiert. In der Fig. 1 sind die Verfahrensschnittstellen I₁₂, I₂₃ zeitlich zwischen dem ersten Modul Modul 1a, Modul 1b und dem zweiten Modul Modul 2 und zwischen dem zweiten Modul Modul 2 und dem dritten Modul Modul 3a und Modul 3b angeordnet. Auch ist eine, in Fig. 1 nicht dargstellte Schnittstelle zwischen dem ersten Modul Modul 1a, Modul 1b und dem dritten Modul Modul 3a, Modul 3b möglich.

Durch entsprechende Definition können weitere Module und Schnittstellen hinzugefügt werden. Weitere Module sind in Fig. 1 durch Punkte angedeutet.

Beispielsweise ist das Modul 1 ein vergrabenes Anschlussgebiet zur elektrischen Kontaktierung eines Kollektorhalbleitergebietes oder eines Emitterhalbleitergebietes des Heterobipolartransistors. Modulvariante 1a weist dabei gegenüber der Modulvariante 1b eine geringere Dotierstoffkonzentration oder einen anderen Dotierstoff auf, so dass das in nachfolgenden Modulen 2 und 3 definierte thermische Budget zu einer unterschiedlichen Ausdiffusion des im Modul 1 eingebrachten Dotierstoffes in darüber angeordnete Halbleiterschichten während der Module 2 und 3 führt.

Ist diese Halbleiterschicht beispielsweise ein aktives Kollektorhalbleitergebiet, erzeugen die beiden Modulvarianten 1a und 1b demzufolge unterschiedliche Kollektordriftzonen für Heterobipolartransistoren mit unterschiedlichen Hochfrequenzeigenschaften. Weiterhin können die Modulvarianten 3a und 3b beispielsweise unterschiedliche Basisgebiete erzeugen.

Wird ausgehend von den, den Modulen zugeordneten Prozessschritten P1 bis P9 eine neue Technologiegeneration mit neuen Heterobipolartransistoren mit beispielsweise eine höheren Durchbruchspannungsfestigkeit gewünscht, wird in diesem Fall lediglich die Prozessschritte P4 bis P7 des Moduls 2 geändert. Die übrigen Prozessschritte P1 bis P3 und P8 bis P9 verbleiben unverändert. Die Änderungsmöglichkeiten der Prozessschritte P4 bis P7 des Moduls 2 sind dabei durch die definierten Schnittstellen I₁₂ und I₂₃ begrenzt. D.h. die durch die Schnittstellen definierten Randbedingungen der Prozessschritte P4 bis P7 bleiben unverändert.

Beispielsweise benötigt Modul 1 gemäß der Verfahrensschnittstelle I₁₂ durch das nachfolgende Modul 2 ein bestimmtes thermisches Budget. Werden die Prozessschritte P4 bis P7 für die neue Technologieversion in neue Prozessschritte (P4' bis P7', in Fig. 1 nicht dargstellt) verändert, ist auf Einhaltung des thermischen Budgets zwingend zu achten. Ist das thermische Budget beispielsweise zu niedrig muss ein thermischer Ersatz-Prozess hinzugefügt werden, der ausschließlich zur Einhaltung der Verfahrensschnittstellenbedingung dient.

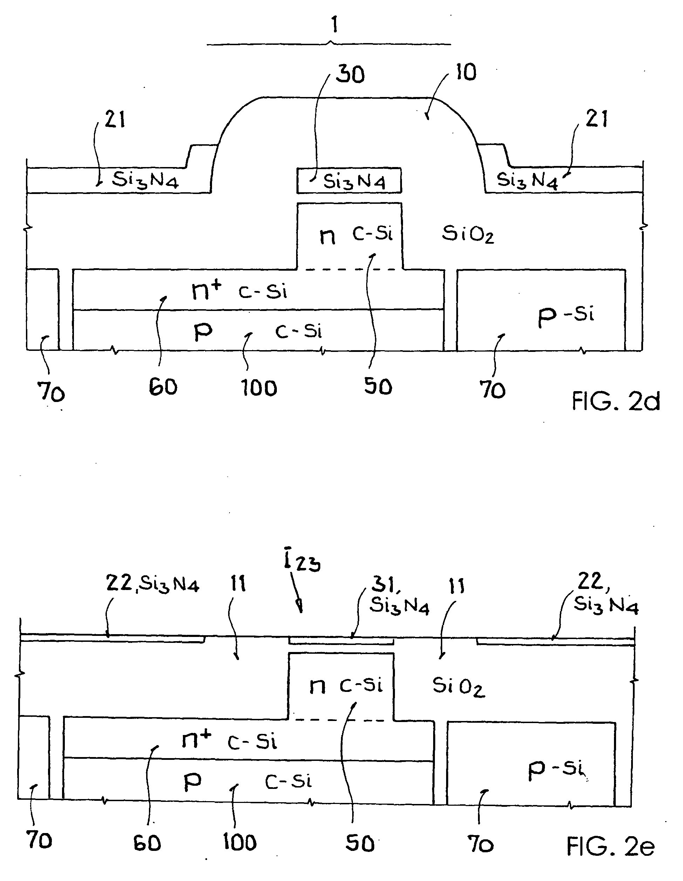

In den Figuren 2a bis 2e werden Prozesse des zweiten Moduls dargestellt, die strukturelle Bedingungen einer Verfahrensschnittstelle I₂₃ definieren. Diese fügt daher die Randbedingung hinzu, dass für Prozessschritte des nachfolgenden Moduls die in Fig. 2d schematisch dargestellte, geometrische Schnittstelle voraus zu setzen ist.

In den Figuren 2a bis 2e sind Schnittansichten eines Ausschnitts eines prozessierten Wafers nach bestimmten Prozessschritten dargestellt. Die Prozessschritte dienen dabei der Erzeugung einer im Wesentlichen planaren Oberfläche ohne Erhebungen, die weiter folgende Prozessschritte beeinflussen könnten.

Es ist ein Teil eines monokristallinen, p-dotierten Siliziumsubstrats 100 dargestellt, auf dem eine hochdotierte, vergrabene Schicht 60 des n-Leitungstyps epitaktisch abgeschieden ist. Auf einem Bereich der vergrabenen Schicht 60 soll in folgenden Prozessschritten - nicht alle davon sind in den Figuren 2a bis 2e dargestellt - ein Heterobipolartransistor erzeugt werden. Zu Isolierung dieses Heterobipolartransistors von weiteren Transistoren oder anderen Bauelementen sind Grabenisolationen vorgesehen, die mit einem polykristallinen Silizium 70 verfüllt sind.

Auf der vergrabenen Schicht 60 ist ein monokristallines Kollektorhalbleitergebiet 50 epitaktisch aufgebracht, das eine geringere Dotierstoffkonzentration aufweist als die vergrabene Schicht 60. Auf dem Kollektorhalbleitergebiet 50 ist eine erste Stoppschicht 30 aus Siliziumnitrid aufgebracht, die von dem Kollektorhalbleitergebiet 50 durch eine dünne Siliziumdioxidschicht getrennt sein kann.

Über die Oberflächenstruktur, die aus der vergrabenen Schicht 60, dem Kollektorhalbleitergebiet 50 und der ersten Stoppschicht 30 besteht*,* wird ein Dielektrikum 10 aus Siliziumdioxid aufgebracht, das eine von der Dicke des Kollektorhalbleitergebietes 50 abhängige Dicke aufweist. Vorzugsweise sind das Kollektorhalbleitergebiet 50 und das Dielektrikum 10 im Rahmen von Fertigungstoleranzen gleich dick.

Die durch die aufgebaute Höhe des Kollektorhalbleitergebietes 50 und der ersten Stoppschicht 30 bedingte, nicht-planare Oberfläche bewirkt beim Aufbringen des Dielektrikums 10 über die gesamte Waferoberfläche, dass im Bereich des Kollektorhalbleitergebietes 50 eine Erhebung 1 innerhalb der Oberfläche des Dielektrikums 10 ausgebildet wird, die die nachfolgenden Prozessschritte zur Erzeugung der Basis (nicht dargestellt) negativ beeinflussen oder verhindern kann.

Um eine planare Oberfläche als Ausgangspunkt für die weiteren Prozessschritte zu erhalten, werden die folgenden, in den Figuren 2a bis 2e zum Teil dargestellten Verfahrensschritte nacheinander durchgeführt. Neben den im Folgenden beschriebenen Verfahrensschritten können weitere Prozessschritte, wie Reinigungsschritte etc. prozesstechnisch notwendig sein, die in dieser Erläuterung zur Vereinfachung fortgelassen sind.

Zuerst wird auf der gesamten Waferoberfläche eine zweite Stoppschicht 20 ganzflächig aufgebracht. Auf dieser Stoppschicht 20 wird ein als Planarisierungsschicht wirkender Photolack 40 auf der gesamten Stoppschichtfläche aufgeschleudert, so dass im Bereich der Erhebungen 1 der Photolack 40 eine geringere Dicke aufweist als außerhalb des Bereichs der Erhebungen 1.

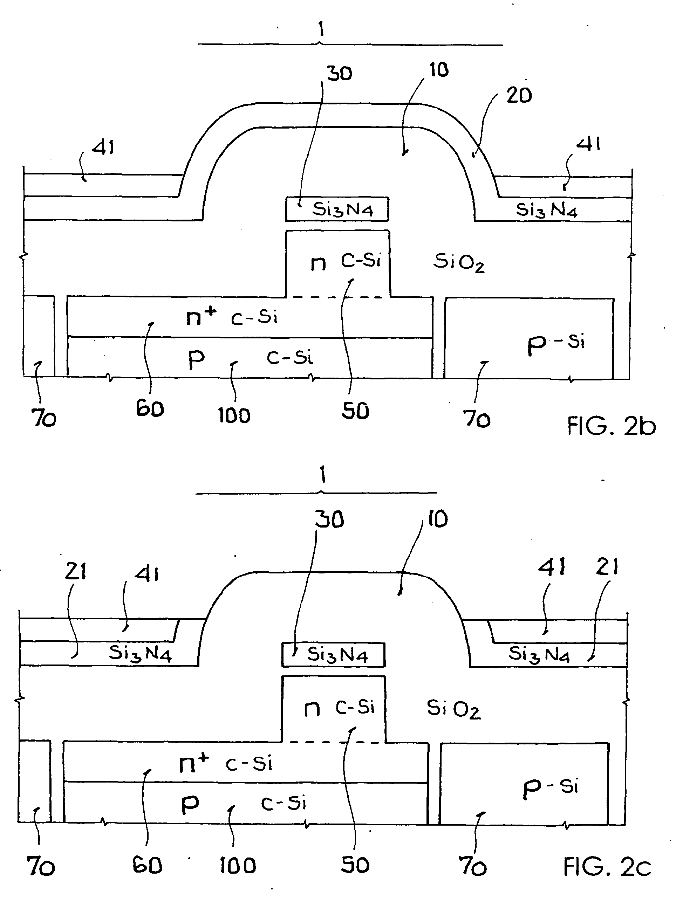

In Fig. 2b ist der Zustand dargestellt, nachdem der aufgebrachte Photolack 40 der Fig. 2a auf Zeit geätzt worden ist. Dabei ist die Ätzzeit derart gewählt, dass außerhalb des Bereichs der Erhebung 1 eine Lackrestschicht 41 verbleibt, die die zweite Stoppschicht 20 im Bereich außerhalb der Erhebung 1 bedeckt. Dabei ist die verbleibende Dicke der Lackrestschicht 41 ausreichend groß, so dass, wie in Fig. 2c dargestellt, die zweite Stoppschicht 20 der Fig. 2b ausschließlich im Bereich der Erhebung 1 geätzt wird. Demnach verbleibt nach der Ätzung die nicht geätzte zweite Stoppschicht 21 unterhalb der Lackrestschicht 41.

Vor einem chemisch-mechanischen Polieren (CMP) der Oberfläche des Wafers, wird, wie in Fig. 2d dargestellt, die Lackrestschicht 41 entfernt. Es verbleiben die innerhalb der Erhebung 1 angeordnete erste Stoppschicht 30 und die nun außerhalb der Erhebung 1 die Oberfläche des Wafers bedeckende, zweite Stoppschicht 21, die beide als Polierstopp wirken.

Fig. 2e zeigt den Zustand des Waferausschnitts nach dem chemisch-mechanischen Polieren (CMP). Der Wafer weist eine plane Oberfläche auf. Die Erhebung 1 der vorhergehenden Figuren ist entfernt. Es sind eine erste Reststoppschicht 31 und eine zweite Reststoppschicht 22 verblieben, die für nachfolgende Prozesse entfernt werden können. Weiterhin sind zwei Dielektrikumbereiche 11 entstanden.

Die erhaltene plane Oberfläche des Wafers ist vorzugsweise eine Verfahrensschnittstellenbedingung einer, zuvor zur Fig. 1 erläuterten, zweiten Verfahrensschnittstelle I₂₃. Weitere Verfahrensschnittstellenbedingungen sind beispielsweise die Dotierstoffkonzentration oder die Gitterfehler an der Grenzfläche des Kollektorhalbleitergebietes 50.

Vorteile des Ausführungsbeispiels der Figuren 2a bis 2e sind, dass durch das Aufbringen der zweiten Stoppschicht kein weiterer Strukturierungsaufwand im Herstellungsprozess entsteht. Unregelmäßigkeiten des chemisch-mechanischen Polierens werden reduziert. Die Uniformität der gesamten Prozessfolge entspricht im Ausführungsbeispiel der Figuren 2a bis 2e im Wesentlichen nur der Uniformität der Dielektrikumbildung. Daher können geringere Toleranzen im Prozessergebnis der gesamten Prozesskette im dargestellten Kollektormodul erzielt werden. Hierdurch ist insbesondere die Herstellung kleinerer Strukturen möglich.

## Patentansprüche

1. Verfahren zur Herstellung integrierter Schaltkreise mit mindestens einem Silizium-Germanium-Heterobipolartransistor, wobei
ein auf die Oberfläche des Wafers aufgebrachtes Dielektrikum (10) planarisiert wird, das Erhebungen (1) aufweist, die durch die Dicke von unterhalb des Dielektrikums (10) strukturierten, monokristallinen Halbleitergebieten (50) verursacht sind, wobei die Halbleitergebiete (50) durch eine erste Stoppschicht (30) bedeckt sind,
indem zur Planarisierung
- auf das Dielektrikum (10) eine zweite Stoppschicht (20) aufgebracht wird,
- nachfolgend auf die zweite Stoppschicht (20) eine Planarisierungsschicht (40) aufgebracht wird, die im Bereich jeder der Erhebungen (1) eine geringere Schichtdicke als außerhalb des Bereichs jeder Erhebung (1) ausbildet,
- nachfolgend die Planarisierungsschicht (40) im Bereich jeder Erhebung (1) *durch Ätzen* entfernt wird, so *dass außerhalb des* Bereichs eine verbliebene Planarisierungsschicht (41) die zweite Stoppschicht (20) bedeckt, **dadurch gekennzeichnet, daß**
- nachfolgend die zweite Stoppschicht (20) ausschließlich im Bereich jeder Erhebung (1) durch Ätzen entfernt wird, und
- nachfolgend der Wafer derart chemisch-mechanisch poliert wird, dass das Dielektrikum (10) im Bereich jeder Erhebung (1) zumindest bis zur ersten Stoppschicht (30) gedünnt wird.

2. Verfahren nach Anspruch 1, **dadurch gekennzeichnet, dass** das vor dem chemisch-mechanischen Polieren (CMP) die außerhalb des Bereichs jeder Erhebung (1) verbliebene Planarisierungsschicht (41) entfernt wird.

3. Verfahren nach einem der Ansprüche 1 oder 2, **dadurch gekennzeichnet, dass** nach dem chemisch-mechanischen Polieren (CMP) die freiliegende erste Stoppschicht (30, 31) und/oder die freiliegende zweite Stoppschicht (21, 22) entfernt werden.

4. Verfahren nach einem der vorhergehenden Ansprüche, **dadurch gekennzeichnet, dass** die Planarisierungsschicht (40) im Bereich jeder Erhebung (1) derart entfernt wird, dass außerhalb des Bereichs jeder Erhebung (1) eine Planarisierungsschicht (41) einer derartigen Dicke verbleibt, die eine Ätzung der von der Planarisierungsschicht (41) bedeckten zweiten Stoppschicht (21) nicht oder nur unwesentlich erfolgt.

5. Verfahren nach einem der vorhergehenden Ansprüche, **dadurch gekennzeichnet, dass** das Dielektrikum (10), die erste Stoppschicht (30) und die zweite Stoppschicht (20) derart aufgebracht werden, dass eine Parallelverschiebung der gleichsinnig orientierten Oberflächen der ersten Stoppschicht (30) und der zweiten Stoppschicht (20) kleiner ist als eine Dicke der ersten Stoppschicht (30) und/oder als eine Dicke der zweiten Stoppschicht (20).

6. Verfahren nach einem der vorhergehenden Ansprüche, **dadurch gekennzeichnet, dass** zum Entfernen der Planarisierungsschicht (40) im Bereich jeder Erhebung (1) die Planarisierungsschicht (40) in Abhängigkeit von einer Zeitmessung geätzt wird.

7. Verfahren nach einem der vorhergehenden Ansprüche, **dadurch gekennzeichnet, dass** die erste Stoppschicht (30, 31) und/oder die zweite Stoppschicht (20, 21, 22) Siliziumnitrid (Si₃N₄) aufweist.

8. Verfahren nach einem der vorhergehenden Ansprüche, **dadurch gekennzeichnet, dass** die Planarisierungsschicht (40, 41) einen Photolack oder ein Polymer aufweist.

9. Verwendung eines Verfahrens nach einem der vorhergehenden Ansprüche zur Herstellung eines integrierten Hochfrequenzschaltkreises mit zumindest einem Silizium-Germanium-Heterobipolartransistor.

## Claims

1. Method for producing integrated circuits with at least one silicon-germanium hetero-bipolar transistor, wherein a dielectric (10) applied to the surface of the wafer is planarised, the dielectric having elevations (1) which are caused by the thickness of monocrystalline semiconductor regions (50) structured below the dielectric (10), wherein the semiconductor regions (50) are covered by a first stop layer (30), in that for planarisation
- a second stop layer (20) is applied to the dielectric (10),
- subsequently a planarisation layer (40) is applied to the second stop layer (20) and forms in the region of each of the elevations (1) a smaller layer thickness than outside the region of each elevation (1),
- subsequently the planarisation layer (40) is removed in the region of each elevation (1) by etching so that outside the region a residual planarisation layer (41) covers the second stop layer (20),
**characterised in that**
- subsequently the second stop layer (20) is removed exclusively in the region of each elevation (1) by etching and
- subsequently the wafer is chemically-mechanically polished in such a manner that the dielectric (10) in the region of each elevation (1) is thinned at least to the first stop layer (30).

2. Method according to claim 1, **characterised in that** before the chemical-mechanical polishing (CMP) the planarisation layer (41) remaining outside the region of each elevation (1) is removed.

3. Method according to one of claims 1 and 2, **characterised in that** after the chemical-mechanical polishing (CMP) the exposed first stop layer (30, 31') and/or the exposed second stop layer (21, 22) is or are removed.

4. Method according to one of the preceding claims, **characterised in that** the planarisation layer (40) is removed in the region of each elevation (1) in such a manner that outside the region of each elevation (1) a planarisation layer (41) remains of such a thickness that an etching of the second stop layer (21) covered by the planarisation layer (41) does not take place or takes place only to an insubstantial extent.

5. Method according to one of the preceding claims, **characterised in that** the dielectric (10), the first stop layer (30) and the second stop layer (20) are applied in such a manner that a parallel displacement of the surfaces, which are oriented in the same sense, of the first stop layer (30) and the second stop layer (20) is smaller than a thickness of the first stop layer (30) and/or than a thickness of the second stop layer (20).

6. Method according to one of the preceding claims, **characterised in that** for removal of the planarisation layer (40) in the region of each elevation (1) the planarisation layer (40) is etched in dependence on a time measurement.

7. Method according to one of the preceding claims, **characterised in that** the first stop layer (30, 31) and/or the second stop layer (20, 21, 22) comprises silicon nitride (Si₃N₄).

8. Method according to one of the preceding claims, **characterised in that** the planarisation layer (40, 41) comprises a photolacquer or a polymer.

9. Use of a method according to one of the preceding claims for producing an integrated high-frequency circuit with at least one silicon-germanium hetero-bipolar transistor.

## Revendications

1. Procédé de fabrication de circuits intégrés comportant au moins un transistor bipolaire à hétérojonction silicium-germanium, dans lequel,
on procède à une opération de planage d'un diélectrique (10) déposé à la surface de la plaquette, qui présente des protubérances (1) créées par l'épaisseur de zones semi-conductrices (50) monocristallines, structurées en-dessous du diélectrique (10), les zones semi-conductrices (50) étant recouvertes d'une première couche d'arrêt (30), l'opération de planage consistant en ce qui suit :
- on dépose une deuxième couche d'arrêt (20) sur le diélectrique (10),
- puis on dépose sur la deuxième couche d'arrêt (20) une couche de planage (40) qui créée une épaisseur de couche plus faible dans la région de chacune des protubérances (1) qu'à l'extérieur de la région de chaque protubérance (1),
- on élimine ensuite la couche de planage (40) dans la région de chaque protubérance (1) par gravure, de sorte qu'à l'extérieur de la région une couche de planage (41) restée en place recouvre la deuxième couche d'arrêt (20),
**caractérisé en ce**
- **qu'**on élimine ensuite par gravure la deuxième couche d'arrêt (20) uniquement dans la région de chaque protubérance (1), et
- et **qu'**on polit ensuite par voie chimico-mécanique la plaquette de telle sorte que le diélectrique (10) s'amincisse dans la région de chaque protubérance (1) au moins jusqu'à la première couche d'arrêt (30).

2. Procédé selon la revendication 1, **caractérisé en ce qu'**avant le polissage chimico-mécanique (CMP ou PMC) on enlève la couche de planage (41) restée en place à l'extérieur de la région de chaque protubérance (1).

3. Procédé selon l'une quelconque des revendications 1 ou 2, **caractérisé en ce qu'**après le polissage chimico-mécanique (CMP ou PMC) on enlève la première couche d'arrêt libre (30, 31) et/ou la deuxième couche d'arrêt libre (21, 22).

4. Procédé selon l'une quelconque des revendications précédentes, **caractérisé en ce que** la couche de planage (40) est enlevée dans la région de chaque protubérance (1) de telle sorte qu'à l'extérieur de la région de chaque protubérance (1) subsiste une couche de planage (41) d'une épaisseur telle que la deuxième couche d'arrêt (21) recouverte par la couche de planage (41) n'est pas ou peu gravée.

5. Procédé selon l'une quelconque des revendications précédentes, **caractérisé en ce que** le diélectrique (10), la première couche d'arrêt (30) et la deuxième couche d'arrêt (20) sont déposés de telle façon qu'un décalage parallèle des surfaces orientées dans le même sens de la première couche d'arrêt (30) et de la deuxième couche d'arrêt (20) est inférieur à une épaisseur de la première couche d'arrêt (30) et/ou à une épaisseur de la deuxième couche d'arrêt (20).

6. Procédé selon l'une quelconque des revendications précédentes, **caractérisé en ce que**, pour enlever la couche de planage (40), on grave dans la région de chaque protubérance (1) la couche de planage (40) en fonction d'un chronométrage.

7. Procédé selon l'une quelconque des revendications précédentes, **caractérisé en ce que** la première couche d'arrêt (30, 31) et/ou la deuxième couche d'arrêt (20,21,22) présentent du nitrure de silicium (Si₃N₄).

8. Procédé selon l'une quelconque des revendications précédentes, **caractérisé en ce que** la couche de planage (40, 41) présente une laque photosensible ou un polymère.

9. Utilisation d'un procédé selon l'une quelconque des revendications précédentes pour la fabrication d'un circuit intégré à haute fréquence comprenant au moins un transistor bipolaire à hétérojonction silicium-germanium.
